# EUROPEAN PATENT SPECIFICATION

(11) **EP 0 901 211 B1**
(45) Date of publication and mention of the grant of the patent: **26.11.2003**
(21) Application number: 98202670.0
(22) Date of filing: 07.08.1998
(51) Int. Cl.: B60R 16/02, H02J 1/14

(54) **Electrical distribution system**
Stromverteilungssystem
Système de distribution d'électricité

(30) Priority: 08.09.1997 GB 9718890
(43) Date of publication of application: 10.03.1999
(73) Proprietor: Delco Electronics Europe GmbH, 65189 Wiesbaden (DE); Delphi Automotive Systems Deutschland GmbH, D-42369 Wuppertal (DE)
(72) Inventor: Hold, Klaus, 42289 Wuppertal (DE); Stadler, Peter, 57482 Wenden (DE); Stein, Thomas, 56271 Kleinmaischeid (DE); Oel, Ludger, 59590 Geseke (DE)
(74) Representative: Denton, Michael John

(56) References cited:
- EP-A- 0 734 905
- WO-A-95/30263
- US-A- 4 028 738
- US-A- 4 534 025
- US-A- 4 906 195
- US-A- 5 424 586
- US-A- 5 428 535

## Description

### Technical Field

The present invention relates to an electrical distribution system for a motor vehicle which is used for the distribution of both electrical power and electrical signals.

### Background of the Invention

Currently, in motor vehicles, electrical power distribution and electrical signal distribution are in general isolated from one another, and/or are provided by numerous separate systems. This leads to complicated wiring harness designs, difficulties in installation in the motor vehicle, and a multitude of system casings and set-ups.

WO 95/30263 A describes a power distribution module in accordance with the preamble of claim 1.

### Summary of the Invention

It is an object of the present invention to simplify the electrical distribution within a motor vehicle.

An electrical distribution system for a motor vehicle in accordance with the present invention is characterised over WO 95/30263 A by the features specified in the characterising portion of claim 1.

The present invention provides a modular arrangement for power and signal distribution which reduces wiring harness complexity, provides easier installation in a motor vehicle, and enables a reduction in the number of variants.

### Brief Description of the Drawings

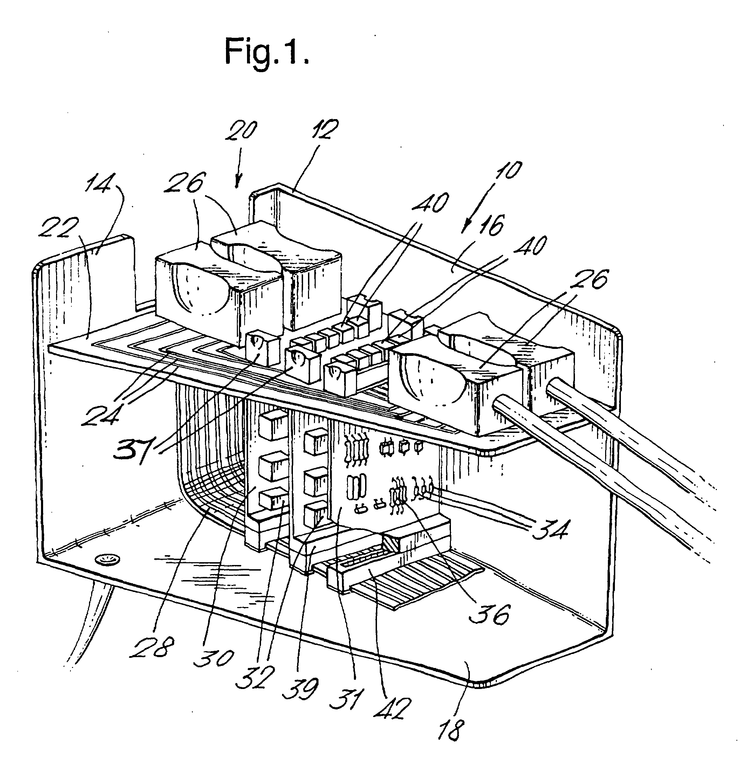

The present invention will now be described, by way of example, with reference to the accompanying drawing, in which:-
Figure 1 is a side view of an electrical distribution system in accordance with the present invention; and

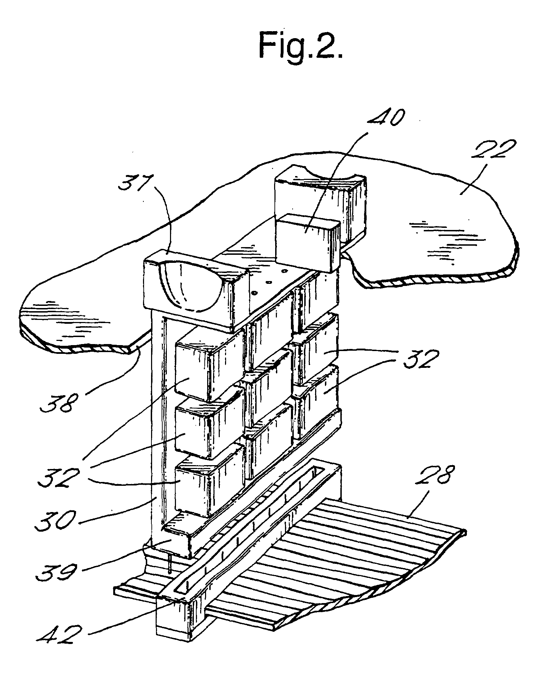

Figure 2 is an enlarged side view of part of the electrical distribution system of Figure 1.

### Description of the Preferred Embodiment

Referring to the Figures, the electrical distribution system 10 for use in a motor vehicle comprises a casing 12 of electrically insulating material having an end wall 14; a side wall 16; a base wall 18; and an open end 20 opposite the base wall. The open portions of the casing 12 may be closed in any suitable manner, and other arrangements for the casing may be used.

A power and signal distribution board 22 is mounted in the casing 12 adjacent the open end 20 thereof, and in a plane substantially parallel to the base wall 18. The board 22 is preferably in the form of a substantially rigid printed circuit board with electrically conductive lines 24 thereon for the distribution of electrical power and electrical signals. Electrical connectors 26 are mounted on the board 22 at each end, or at any other suitable location, and make electrical connection with the lines 24 for the input and output of both electrical power and electrical signals to and from the system 10.

A ribbon cable 28 extends from the board 22 adjacent the end wall 14 and then across the base wall 18. The ribbon cable is electrically connected to the board 22 adjacent the end wall 14 of the casing 12. The ribbon cable 28 also provides for electrical signal distribution in the system 10. As an alternative, the ribbon cable may be replaced by a flexible printed circuit, a flexible flat circuit, or a moulded interconnection device.

A number of control boards 30,31 extend between the board 22 and the ribbon cable 28. The control boards 30,31 are preferably slidably mounted in grooves (not shown) formed on the side wall 16 of the casing 12, and in a plane substantially perpendicular to the board 22. The control boards 30,31 are preferably substantially rigid printed circuit boards with electrically conductive lines (not shown) formed thereon. One or more of the control boards 30 has one or more relays 32 mounted thereon which are electrically connected with the electrically conductive lines formed on the control board. One or more of the control boards 31 has electronic components 34 mounted thereon, and may also include one or more microcomputers 36 mounted thereon which are electrically connected with the electrically conductive lines formed on the control board. At one end 37, each control board 30,31 extends through a corresponding aperture 38 in the board 22. Electrical connections are made between the lines 24 on the board 22 and the lines on the control boards 30,31 by way of electrical fuses or circuit breakers 40, or by a straight connection. At the other end 39, each control board 30,31 makes an electrical connection with the ribbon cable 28 by way of an electrical connector 42. The electrical connectors 42 are preferably either known card insert connectors or known insulation piercing connectors.

With the present invention, power distribution and signal distribution for a motor vehicle can be combined within a casing which can be assembled before installation on a motor vehicle. Power distribution from a vehicle battery (not shown) to the electrical loads (not shown) in a vehicle is by way of the board 22, the fuses/circuit breakers 40 and the relays 32. The microcomputers 36 and electronic components 34 receive and send signals by way the board 22 and the ribbon cable 28 to monitor and control the operation of the relays 32, and to monitor and control the operation of other electrical components in the motor vehicle. The present invention therefore provides a modular arrangement for combining power and signal distribution. Such an arrangement reduces the complexity of vehicle wiring harnesses and provides for easier installation in a motor vehicle.

The relays 32 may be replaced by any other suitable electrically controllable switching device, such as MOSFETs. The fuses/circuit breakers 40 may be replaced by any other suitable overload protection devices. The microcomputers 36 may be replaced by any other suitable form of logic control means or semiconductor control device. The electrical connectors 26 may be replaced by any other suitable form of electrical connection means.

The present invention also lends itself for easy modification dependent on the vehicle within which the system is to be installed, and dependent on customer requirements for the vehicle, thereby reducing variants.

## Claims

1. An electrical distribution system for a motor vehicle comprising a board (22) for power distribution; electrical connection means (26) for connection to a power supply, to one or more electrical loads, and for signal distribution; signal distribution means (28) for receiving and transmitting electrical signals; electrically operable switch means (32) for switching the power supply between the electrical connection means; electronic control means (34,36) for controlling the operation of the switch means dependent on signals received on the signal distribution means; and a casing (12) within which the board and the signal distribution means are mounted;
**characterised in that** the board (22) is also for signal distribution;
**in that** the electrical connection means (26) is mounted on the board;
by at least one control board (30,31), mounted within the casing (12), extending between, and electrically connectable with, the power and signal distribution board (22) and the signal distribution means (28);
**in that** the electrically operable switch means (32) is mounted on the at least one control board; and
**in that** the control means (34,36) is mounted on the at least one control board.

2. An electrical distribution system as claimed in Claim 1, comprising at least first and second control boards, the first control board (30) having the electrically operable switch means (32) mounted thereon, and the second control board (31) having the electronic control means (34,36) mounted thereon.

3. An electrical distribution system as claimed in Claim 1 or Claim 2, wherein electrical fuses or circuit breakers (40) provide the electrical connection between the or each control board (30,31) and the power and signal distribution board (22).

4. An electrical distribution system as claimed in Claim 2 or Claim 3, wherein the or each control board (30,31) extends through a corresponding aperture (38) in the power and signal distribution board (22) at one end (37) of the control board, the fuses or circuit breakers (40) being positioned at said one end.

5. An electrical distribution system as claimed in any one of Claims 1 to 4, wherein the signal distribution means is a ribbon cable (28).

6. An electrical distribution system as claimed in any one of Claims 1 to 5, wherein the power and signal distribution board (22) and/or the control boards (30,31) are substantially rigid printed circuit boards having electrically conductive lines (24) formed thereon.

## Patentansprüche

1. Elektrisches Verteilungssystem für ein Kraftfahrzeug mit einer Platine (22) zur Energieverteilung, einem elektrischen Verbindungsmittel (26) zur Verbindung mit einer Energieversorgung, mit einer oder mehreren elektrischen Lasten und zur Signalverteilung, einem Signalverteilungsmittel (28) zum Empfangen und Senden elektrischer Signale, einem elektrisch betreibbaren Schaltmittel (32) zum Schalten der Energieversorgung zwischen das elektrische Verbindungsmittel, einem elektronischen Steuermittel (34, 36) zum Steuern des Betriebes des Schaltmittels in Abhängigkeit von Signalen, die von dem Signalverteilungsmittel empfangen werden, und einem Gehäuse (12), in dem die Platine und das Signalverteilungsmittel befestigt sind,
**gekennzeichnet dadurch, dass** die Platine (22) auch zur Signalverteilung dient,
dass das elektrische Verbindungsmittel (26) auf der Platine befestigt ist,
durch zumindest eine Steuerplatine (30, 31), die in dem Gehäuse (12) befestigt ist und sich zwischen der Energie- und Signalverteilungsplatine (22) und dem Signalverteilungsmittel (28) erstreckt und elektrisch mit diesen verbindbar ist,
dass das elektrisch betreibbare Schaltmittel (32) auf der zumindest einen Steuerplatine befestigt ist, und
dass das Steuermittel (34, 36) auf der zumindest einen Steuerplatine befestigt ist.

2. Elektrisches Verteilungssystem nach Anspruch 1 mit zumindest einer ersten und einer zweiten Steuerplatine, wobei auf der ersten Steuerplatine (30) das elektrisch betreibbare Schaltmittel (32) befestigt ist, und wobei auf der zweiten Steuerplatine (31) das elektronische Steuermittel (34, 36) befestigt ist.

3. Elektrisches Verteilungssystem nach Anspruch 1 oder Anspruch 2, wobei elektrische Sicherungen oder Trennschalter (40) die elektrische Verbindung zwischen der oder jeder Steuerplatine (30, 31) und der Energie- und Signalverteilungsplatine (22) bereitstellen.

4. Elektrisches Verteilungssystem nach Anspruch 2 oder Anspruch 3, wobei die oder jede Steuerplatine (30, 31) sich durch eine entsprechende Öffnung (38) in der Energie- und Signalverteilungsplatine (22) an einem Ende (37) der Steuerplatine erstreckt, wobei die Sicherungen oder Trennschalter (40) an dem einen Ende angeordnet sind.

5. Elektrisches Verteilungssystem nach einem der Ansprüche 1 bis 4, wobei das Signalverteilungsmittel ein Flachkabel (28) ist.

6. Elektrisches Verteilungssystem nach einem der Ansprüche 1 bis 5, wobei die Energie- und Signalverteilungsplatine (22) und/oder die Steuerplatinen (30, 31) im Wesentlichen starre gedruckte Schaltungsplatinen sind, auf denen elektrisch leitende Leitungen (24) gebildet sind.

## Revendications

1. Système de distribution d'électricité destiné à un véhicule à moteur comprenant une carte (22) de distribution d'électricité ; des moyens de connexion électriques (26) pour un raccordement à une alimentation électrique, à une ou plusieurs charges électriques, et pour la distribution de signaux ; des moyens de distribution de signaux (28) afin de recevoir et d'émettre des signaux électriques ; des moyens de commutation susceptibles de fonctionner de manière électrique (32) afin de commuter l'alimentation électrique entre les moyens de connexion électriques ; des moyens de commande électroniques (34, 36) afin de commander le fonctionnement des moyens de commutation selon les signaux reçus sur les moyens de distribution de signaux ; et un boîtier (12) à l'intérieur duquel la carte et les moyens de distribution de signaux sont montés ;
**caractérisé en ce que** la carte (22) sert également à la distribution de signaux ;
**en ce que** les moyens de connexion électriques (26) sont montés sur la carte ;
par au moins une carte de commande (30, 31), montée à l'intérieur du boîtier (12), qui s'étend entre, et susceptible d'être connectée de manière électrique à, la carte de distribution de la puissance et des signaux (22) et les moyens de distribution de signaux (28) ;
**en ce que** les moyens de commutation susceptibles de fonctionner de manière électrique (32) sont montés sur la au moins une carte de commande ; et
**en ce que** les moyens de commande (34, 36) sont montés sur la au moins une carte de commande.

2. Système de distribution d'électricité selon la revendication 1, comprenant au moins une première et une seconde cartes de commande, la première carte de commande (30) ayant les moyens de commutation susceptibles de fonctionner de manière électrique (32) montés dessus, et la seconde carte de commande (31) ayant les moyens de commande électronique (34, 36) montés dessus.

3. Système de distribution d'électricité selon l'une quelconque des revendications 1 ou 2, dans lequel les fusibles ou les disjoncteurs électriques (40) fournissent le raccordement électrique entre la, ou chaque, carte de commande (30, 31) et la carte de distribution de la puissance et des signaux (22).

4. Système de distribution d'électricité selon l'une quelconque des revendications 2 ou 3, dans lequel la, ou chaque, carte de commande (30, 31) s'étend à travers une ouverture correspondante (38) dans la carte de distribution de la puissance et des signaux (22) à une extrémité (37) de la carte de commande, les fusibles ou les disjoncteurs (40) étant placés à ladite une extrémité.

5. Système de distribution d'électricité selon l'une quelconque des revendications 1 à 4, dans lequel les moyens de distribution des signaux sont un câble plat (28).

6. Système de distribution d'électricité selon l'une quelconque des revendications 1 à 5, dans lequel la carte de distribution de la puissance et des signaux (22) et / ou les cartes de commande (30, 31) sont des cartes de circuit imprimé sensiblement rigides ayant des lignes conductrices de manière électrique (24) formées dessus.
